# EUROPÄISCHE PATENTANMELDUNG

(11) **EP 4 036 591 A1**
(43) Veröffentlichungstag der Anmeldung: **03.08.2022**
(21) Anmeldenummer: 22152357.4
(22) Anmeldetag: 20.01.2022
(51) Int. Cl.: G01R 31/364, G01R 31/396

(54) **BATTERIEZELLE MIT ÜBERWACHUNGSEINRICHTUNG**

(30) Priorität: 22.01.2021 DE 102021200571
(71) Anmelder: Siemens Mobility GmbH, 81739 München (DE)
(72) Erfinder: Glinka, Martin, 91054 Buckenhof (DE); Jaumann, Tony, 90419 Nürnberg (DE); Probst, Sebastian, 90408 Nürnberg (DE)

(57) **Zusammenfassung**

Die Erfindung bezieht sich unter anderem auf eine Batteriezelle (20) mit einer Überwachungseinrichtung (10), die geeignet ist, zumindest einen die Batteriezelle (20) betreffenden stromabhängigen Messwert (Mi) zu erfassen.

Erfindungsgemäß ist vorgesehen, dass die Überwachungseinrichtung (10) einen Magnetfeldsensor (13, 13a, 13b) umfasst, der geeignet ist, ein von einem durch die Batteriezelle (20) fließenden elektrischen Batteriezellenstrom (I) erzeugtes Magnetfeld (B) unter Bildung eines magnetfeldbezogenen Messwerts (Mm, Mm1, Mm2) zu erfassen und die Überwachungseinrichtung (10) den magnetfeldbezogenen Messwert (Mm, Mm1, Mm2) unmittelbar als den stromabhängigen Messwert (Mi) weiterverarbeitet oder den stromabhängigen Messwert (Mi) mit dem magnetfeldbezogenen Messwert (Mm, Mm1, Mm2) bildet.

## Beschreibung

Die Erfindung bezieht sich auf eine Batteriezelle mit einer Überwachungseinrichtung, die geeignet ist, zumindest einen die Batteriezelle betreffenden stromabhängigen Messwert zu erfassen.

Eine derartige Batteriezelle ist aus der europäischen Offenlegungsschrift EP 2 642 574 A1 bekannt.

Der Erfindung liegt die Aufgabe zugrunde, eine Batteriezelle anzugeben, bei der die Überwachungseinrichtung den stromabhängigen Messwert in besonders einfacher Weise, aber dennoch mit Blick auf die Erfassung eines Batteriefehlers zuverlässig erfassen kann.

Diese Aufgabe wird erfindungsgemäß durch eine Batteriezelle mit den Merkmalen gemäß Patentanspruch 1 gelöst. Vorteilhafte Ausgestaltungen der erfindungsgemäßen Batteriezelle sind in Unteransprüchen angegeben.

Danach ist erfindungsgemäß vorgesehen, dass die Überwachungseinrichtung einen Magnetfeldsensor umfasst, der geeignet ist, ein von einem durch die Batteriezelle fließenden elektrischen Batteriezellenstrom erzeugtes Magnetfeld unter Bildung eines magnetfeldbezogenen Messwerts zu erfassen, und die Überwachungseinrichtung den magnetfeldbezogenen Messwert unmittelbar als den stromabhängigen Messwert weiterverarbeitet oder den stromabhängigen Messwert mit dem magnetfeldbezogenen Messwert bildet.

Ein wesentlicher Vorteil der erfindungsgemäßen Batteriezelle besteht in der Ausgestaltung der Überwachungseinrichtung, die einen magnetfeldbezogenen Messwert eines Magnetfeldsensors unmittelbar als stromabhängigen Messwert weiterverarbeitet oder den stromabhängigen Messwert mit dem magnetfeldbezogenen Messwert bildet. Durch Auswerten eines Magnetfelds lassen sich in sehr einfacher Weise, aber dennoch sehr zuverlässig, Rückschlüsse auf den durch die Batteriezelle fließenden Batteriezellenstrom ziehen und dadurch beispielsweise Kurzschlüsse in der Batterie erkennen.

Vorteilhaft ist es, wenn die Überwachungseinrichtung von den Batteriepolen der Batteriezelle elektrisch getrennt ist und eine Energieversorgung der Überwachungseinrichtung auf einer induzierten elektrischen Spannung und/oder einem induzierten elektrischen Strom basiert, die bzw. der im Falle eines sich ändernden Magnetfelds in der Überwachungseinrichtung induziert wird.

Der Magnetfeldsensor ist vorzugsweise asymmetrisch zu den Batteriepolen der Batteriezelle angeordnet.

Der Magnetfeldsensor ist vorzugsweise ein Feldstärkesensor, der die magnetische Feldstärke des Magnetfelds misst, oder ein Flusssensor, der den magnetischen Fluss des Magnetfelds misst.

Vorteilhaft ist es, wenn der Magnetfeldsensor ein Hallsensor, ein magnetoresistiver Sensor, ein magnetomechanischer Sensor, ein GMR-Sensor bzw. ein riesenmagnetowiderstandsbasierter Sensor, ein TMR-Sensor bzw. magnetischer tunnelwiderstandsbasierter Sensor oder ein Rogowskispulensensor ist.

Mit Blick darauf, externe Magnetfelder möglichst unberücksichtigt zu lassen bzw. bei der Messung zu unterdrücken, wird es als vorteilhaft angesehen, wenn die Überwachungseinrichtung zumindest einen ersten und einen zweiten Magnetfeldsensor umfasst, die jeweils geeignet sind, ein von einem durch die Batteriezelle fließenden elektrischen Batteriezellenstrom erzeugtes Magnetfeld unter Bildung eines stromabhängigen Hilfsmesswerts zu erfassen, wobei der erste Magnetfeldsensor näher am Pluspol der Batteriezelle angeordnet ist als der zweite Magnetfeldsensor und einen ersten stromabhängigen Hilfsmesswert bildet, der zweite Magnetfeldsensor näher am Minuspol der Batteriezelle angeordnet ist als der erste Magnetfeldsensor und einen zweiten stromabhängigen Hilfsmesswert bildet und die Überwachungseinrichtung die Differenz zwischen den beiden Hilfsmesswerten bildet und die Differenz als den stromabhängigen Messwert weiterverarbeitet.

Die Überwachungseinrichtung erzeugt vorzugsweise ein stromabhängiges Warnsignal, wenn der stromabhängige Messwert einen vorgegebenen Stromgrenzwert, der einen unzulässig hohen Batteriezellenstrom signalisiert, erreicht oder überschreitet. Zusätzlich werden das Warnsignal, der stromabhängige Messwert und/oder der Umstand, dass der stromabhängige Messwert den Stromgrenzwert überschritten hat, in einem Speicher abgespeichert, vorzugsweise unlöschbar bzw. unmanipulierbar und vorzugsweise mit Zeitangabe, sei es in Form einer unmittelbaren Zeitangabe oder in Form einer mittelbaren Zeitangabe, beispielsweise in Form einer zeitlichen Reihenfolge, die eine zeitliche Zuordnung ermöglicht.

Die Überwachungseinrichtung erzeugt das stromabhängige Warnsignal vorzugsweise dann, wenn sie mit induzierter Energie versorgt wird.

Die Überwachungseinrichtung umfasst vorzugsweise einen Beschleunigungssensor, der geeignet ist, die Beschleunigung unter Bildung eines Beschleunigungsmesswerts zu erfassen.

Die Überwachungseinrichtung erzeugt vorzugsweise ein beschleunigungsbezogenes Warnsignal, wenn der Beschleunigungsmesswert einen vorgegebenen Beschleunigungsgrenzwert oder ein durch zeitliche Ableitung des Beschleunigungsmesswerts ermittelter Stoßmesswert einen vorgegebenen Stoßgrenzwert erreicht oder überschreitet.

Auch ist es vorteilhaft, wenn das beschleunigungsbezogene Warnsignal, der Beschleunigungsmesswert, der Stoßmesswert und/oder der Umstand, dass der Beschleunigungsgrenzwert oder der Stoßgrenzwert überschritten wurde, in einem Speicher abgespeichert werden, vorzugsweise unlöschbar bzw. unmanipulierbar und vorzugsweise mit Zeitangabe.

Die Überwachungseinrichtung weist vorzugsweise einen Temperatursensor, der geeignet ist, die Temperatur unter Bildung eines Temperaturmesswerts zu erfassen, auf.

Die Überwachungseinrichtung erzeugt vorzugsweise ein temperaturbezogenes Warnsignal, wenn der Temperaturmesswert einen vorgegebenen Temperaturgrenzwert erreicht oder überschreitet.

Auch ist es vorteilhaft, wenn das temperaturbezogene Warnsignal, der Temperaturmesswert und/oder der Umstand, dass der Temperaturmesswert den Temperaturgrenzwert überschritten hat, in einem Speicher abgespeichert werden, vorzugsweise unlöschbar bzw. unmanipulierbar und vorzugsweise mit Zeitangabe.

Der Temperatursensor ist vorzugsweise an der im Betrieb der Batteriezelle wärmsten Stelle angeordnet.

Die Überwachungseinrichtung weist vorzugsweise einen Speicher auf, in dem die Überwachungseinrichtung erfasste Strommesswerte, Beschleunigungsmesswerte, Stoßmesswerte und/oder Temperaturmesswerte dauerhaft abspeichert.

Die Überwachungseinrichtung weist vorzugsweise eine Sendeeinrichtung auf, die geeignet ist, erfasste Strommesswerte, Beschleunigungsmesswerte, Stoßmesswerte, Temperaturmesswerte, Zustandsangaben, die auf Strommesswerten, Beschleunigungsmesswerten, Stoßmesswerten und/oder Temperaturmesswerten basieren, und/oder Warnsignale per Funk auszusenden.

Der Überwachungseinrichtung und damit der Batteriezelle ist vorzugsweise eine Identifikationsangabe zugeordnet, die in einem Chip der Überwachungseinrichtung oder einem die Überwachungseinrichtung bildenden Chip abgespeichert ist.

Die Überwachungseinrichtung ist vorzugsweise innerhalb oder außerhalb des Batteriezellengehäuses unter Bildung einer gemeinsamen Baueinheit fest angebracht.

Die Erfindung bezieht sich darüber hinaus auf eine Batterie, die mit ein oder mehr Batteriezellen ausgestattet ist. Erfindungsgemäß ist bezüglich einer solchen Batterie vorgesehen, dass die Batteriezellen - oder zumindest eine von ihnen - wie oben beschrieben ausgestaltet sind, also jeweils eine entsprechende Überwachungseinrichtung aufweisen.

Bezüglich der Vorteile der erfindungsgemäßen Batterie sei auf die obigen Ausführungen im Zusammenhang mit der erfindungsgemäßen Batteriezelle verwiesen.

Die Erfindung bezieht sich darüber hinaus auf ein Verfahren zum Überwachen einer Batteriezelle unter Erfassung zumindest eines stromabhängigen Messwerts.

Erfindungsgemäß ist bezüglich des Verfahrens vorgesehen, dass mit einem Magnetfeldsensor ein von einem durch die Batteriezelle fließenden elektrischen Batteriezellenstrom erzeugtes Magnetfeld unter Bildung eines magnetfeldbezogenen Messwerts erfasst wird und der magnetfeldbezogene Messwert unmittelbar als der stromabhängige Messwert weiterverarbeitet wird oder der stromabhängige Messwert mit dem magnetfeldbezogenen Messwert gebildet wird.

Bezüglich der Vorteile des erfindungsgemäßen Verfahrens und dessen vorteilhafter Ausgestaltungen sei auf die obigen Ausführungen im Zusammenhang mit der erfindungsgemäßen Batteriezelle und deren vorteilhafter Ausgestaltungen verwiesen.

Die Erfindung wird nachfolgend anhand von Ausführungsbeispielen näher erläutert; dabei zeigen beispielhaft
- Fig. 1 bis 4: Ausführungsbeispiele für Überwachungseinrichtungen, die für erfindungsgemäße Batteriezellen geeignet sind, und
- Fig. 5 bis 9: Ausführungsbeispiele für erfindungsgemäße Batteriezellen, die mit Überwachungseinrichtungen ausgestattet sind.

In den Figuren werden der Übersicht halber für identische oder vergleichbare Komponenten stets dieselben Bezugszeichen verwendet.

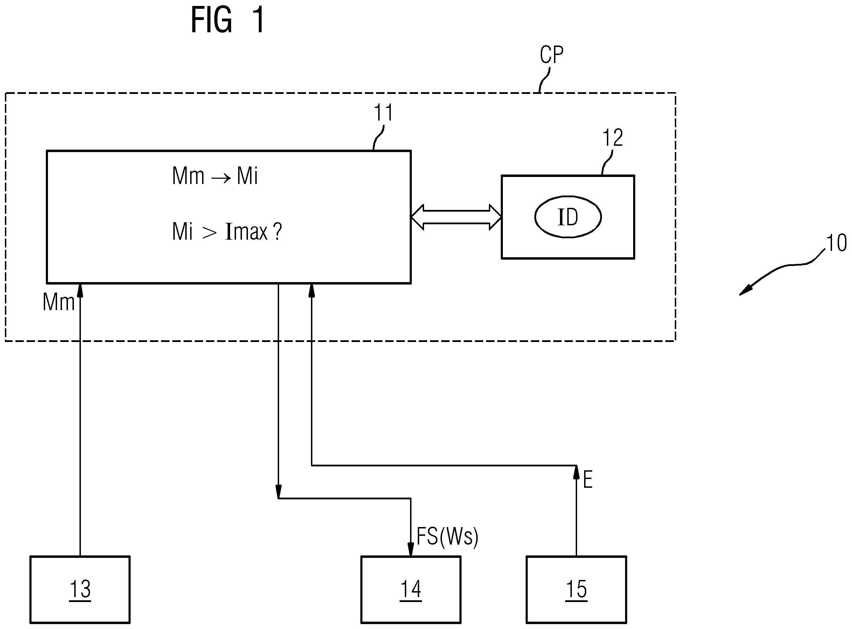

Die Figur 1 zeigt ein Ausführungsbeispiel für eine Überwachungseinrichtung 10, die eine Auswerteinrichtung 11 als zentrales Element sowie darüber hinaus weitere, weiter unten beschriebene Bestandteile aufweist und für eine in der Figur 1 aus Gründen der Übersicht nicht gezeigte Batteriezelle geeignet ist.

Die Auswerteinrichtung 11 steht mit einem Speicher 12 in Verbindung, in dem eine die Überwachungseinrichtung 10 als solche und damit eine mit der Überwachungseinrichtung 10 ausgestattete Batteriezelle eindeutig identifizierbare Identifikationsangabe ID abgespeichert ist. Die Auswerteinrichtung 11 und der Speicher 12 sind vorzugsweise in einem gemeinsamen Chip CP integriert.

Mit der Auswerteinrichtung 11 steht ein Magnetfeldsensor 13 in Verbindung, der ein äußeres Magnetfeld unter Bildung eines magnetfeldbezogenen Messwerts Mm erfassen kann. Da von einem durch die Batteriezelle fließenden elektrischen Batteriezellenstrom ein Magnetfeld erzeugt wird, ist der magnetfeldbezogene Messwert Mm batteriezellenstromabhängig, nachfolgend nur kurz als stromabhängig bezeichnet, sodass der Magnetfeldsensor 13 der Überwachungseinrichtung 10 somit in der Lage ist, zumindest mittelbar bzw. indirekt den Batteriezellenstrom zu messen.

Der magnetfeldbezogene Messwert Mm des Magnetfeldsensors 13 gelangt zu der Auswerteinrichtung 11, die den magnetfeldbezogenen Messwert Mm unmittelbar als stromabhängigen Messwert Mi weiterverwendet, indem sie beispielsweise diesen nur betragsmäßig und ohne physikalische Einheit berücksichtigt, oder den stromabhängigen Messwert Mi auf der Basis des magnetfeldbezogenen Messwerts Mm berechnet, beispielsweise unter Heranziehung einer mathematischen Umrechnungsfunktion.

Die Auswerteinrichtung 11 ist vorzugsweise derart ausgestaltet, dass sie ein stromabhängiges Warnsignal Ws erzeugt, wenn der stromabhängige Messwert Mi einen vorgegebenen Stromgrenzwert Imax, der einen unzulässig hohen Batteriezellenstrom signalisiert, erreicht oder überschreitet. Zusätzlich werden das Warnsignal Ws, der stromabhängige Messwert Mi und/oder der Umstand, dass der stromabhängige Messwert Mi den Stromgrenzwert Imax überschritten hat, in dem Speicher 12 abgespeichert, vorzugsweise unlöschbar bzw. unmanipulierbar und vorzugsweise mit Zeitangabe.

Vorteilhaft ist es, wenn die Auswerteinrichtung 11 mit einer Sendeeinrichtung 14, beispielsweise in Form einer Sendeantenne, ausgestattet ist, die das stromabhängige Warnsignal Ws als Funksignal FS oder gemeinsam mit diesem aussendet. Ein solches Funksignal FS kann beispielsweise von einer externen, in der Figur 1 nicht gezeigten Zentraleinrichtung empfangen werden, die bei Vorliegen des Funksignals FS bzw. des stromabhängigen Warnsignals Ws den Batteriezellenstrom durch die Batteriezelle abschaltet.

Zur Stromversorgung der Überwachungseinrichtung 10 kann die Energie der Batteriezelle, die von der Überwachungseinrichtung 10 überwacht wird, herangezogen werden; zu diesem Zwecke kann die Überwachungseinrichtung 10 an die Batteriepole der Batteriezelle angeschlossen werden.

Besonders vorteilhaft ist es jedoch, wenn die Überwachungseinrichtung 10 mit einer Induktionseinrichtung 15, beispielsweise in Form einer Induktionsschleife, ausgestattet ist und ihre Betriebsenergie E aus einem Magnetfeld, das die Induktionseinrichtung 15 durchsetzt, entnimmt. Mit anderen Worten ist es also besonders vorteilhaft, wenn die Überwachungseinrichtung 10 von den Batteriepolen der Batteriezelle elektrisch getrennt ist und eine Energieversorgung der Überwachungseinrichtung 10 auf einer induzierten elektrischen Spannung und/oder einem induzierten elektrischen Strom basiert, die bzw. der im Falle eines sich ändernden Magnetfelds in der Induktionseinrichtung 15 induziert wird.

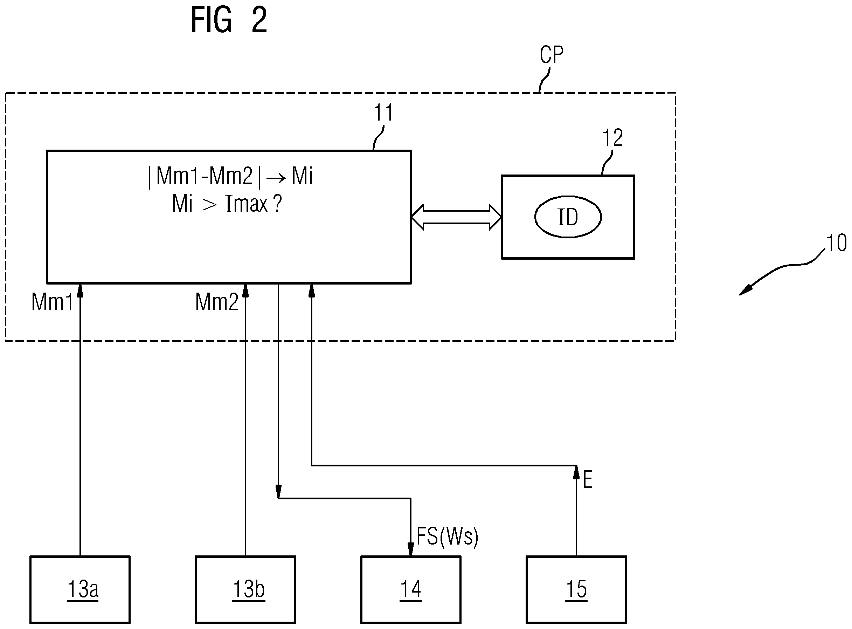

Die Figur 2 zeigt eine besonders bevorzugte Ausführungsvariante der Überwachungseinrichtung 10 gemäß Figur 1. Bei der Ausführungsvariante gemäß Figur 2 umfasst die Überwachungseinrichtung 10 zwei Magnetfeldsensoren 13a und 13b, nachfolgend auch erster Magnetfeldsensor 13a und zweiter Magnetfeldsensor 13b genannt. Die beiden Magnetfeldsensoren 13a und 13b sind jeweils geeignet, ein Magnetfeld, also auch ein von einem durch die Batteriezelle fließenden elektrischen Batteriezellenstrom erzeugtes Magnetfeld, unter Bildung eines stromabhängigen Hilfsmesswerts zu erfassen.

Der erste Magnetfeldsensor 13a wird beispielsweise näher am Pluspol der Batteriezelle angeordnet als der zweite Magnetfeldsensor und bildet einen ersten stromabhängigen Hilfsmesswert Mm1.

Der zweite Magnetfeldsensor 13b wird beispielsweise näher am Minuspol der Batteriezelle angeordnet als der erste Magnetfeldsensor 13a und bildet einen zweiten stromabhängigen Hilfsmesswert Mm2.

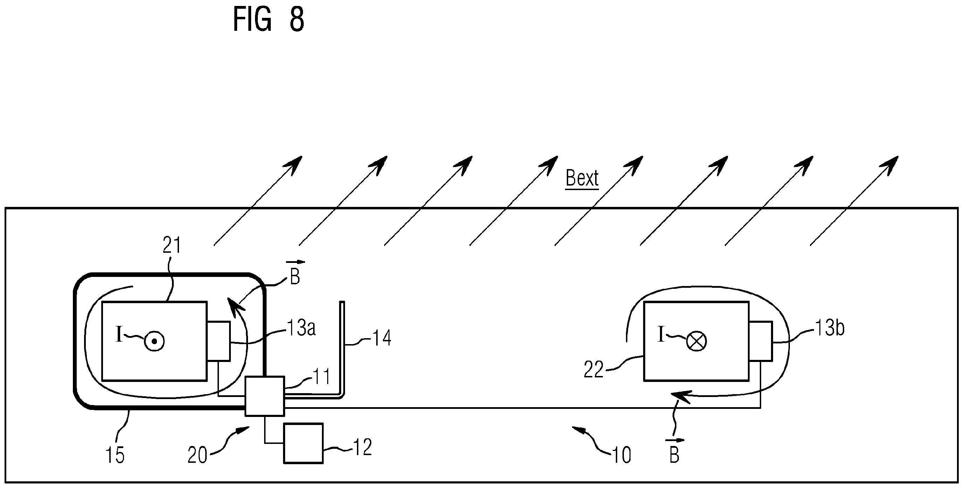

Die Auswerteinrichtung 11 bildet - vorzeichenrichtig - die Differenz Mm1-Mm2 zwischen den beiden Hilfsmesswerten und verarbeitet die Differenz als den stromabhängigen Messwert Mi weiter, wie dies oben im Zusammenhang mit der Figur 1 erläutert wurde, oder bildet diesen auf der Basis der Differenz Mm1-Mm2. Werden, wie bereits erwähnt und wie weiter unten im Zusammenhang mit der Figur 8 noch näher erläutert wird, die Magnetfeldsensoren 13a und 13b jeweils im Bereich von Plus-und Minuspol angeordnet, so berücksichtigt die Differenzbildung die unterschiedliche Richtung der Magnetfeldlinien, die von dem Batteriezellenstrom hervorgerufen werden, sodass ein beide Magnetfeldsensoren 13a und 13b beeinflussendes externes Magnetfeld herausgerechnet wird und damit unberücksichtigt bleibt.

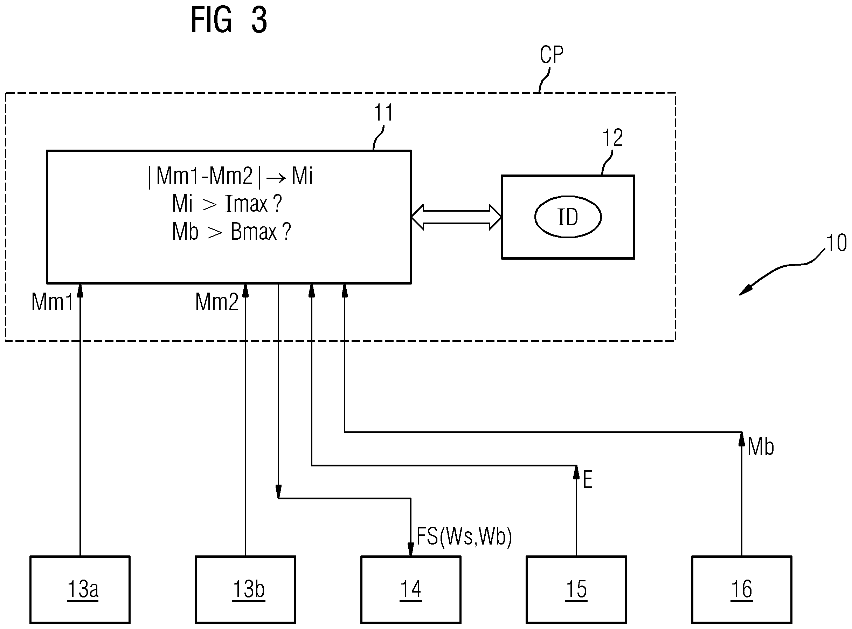

Die Figur 3 zeigt ein drittes Ausführungsbeispiel für eine Überwachungseinrichtung 10, die zur Überwachung einer Batteriezelle einsetzbar ist. Im Unterschied zu den Ausführungsbeispielen gemäß den Figuren 1 und 2 weist die Überwachungseinrichtung 10 gemäß Figur 3 zusätzlich einen Beschleunigungssensor 16 auf. Der Beschleunigungssensor 16 ist geeignet, die Beschleunigung der Überwachungseinrichtung 10 und damit die Beschleunigung der mit der Überwachungseinrichtung 10 ausgestatteten Batteriezelle unter Bildung eines Beschleunigungsmesswerts Mb zu erfassen.

Die Auswerteinrichtung 11 erzeugt ein beschleunigungsbezogenes Warnsignal Wb, wenn der Beschleunigungsmesswert Mb einen vorgegebenen Beschleunigungsgrenzwert Bmax oder ein durch zeitliche Ableitung des Beschleunigungsmesswerts Mb ermittelter Stoßmesswert dMb/dt einen vorgegebenen Stoßgrenzwert erreicht oder überschreitet. Das beschleunigungsbezogene Warnsignal Wb wird vorzugsweise als Funksignal FS oder zusammen mit diesem an die externe Zentraleinrichtung übermittelt.

Auch ist es vorteilhaft, wenn das beschleunigungsbezogene Warnsignal Wb, der Beschleunigungsmesswert Mb, der Stoßmesswert dMb/dt und/oder der Umstand, dass der Beschleunigungsgrenzwert Bmax oder der Stoßgrenzwert überschritten wurde, in dem Speicher 12 abgespeichert werden, vorzugsweise unlöschbar bzw. unmanipulierbar und vorzugsweise mit Zeitangabe.

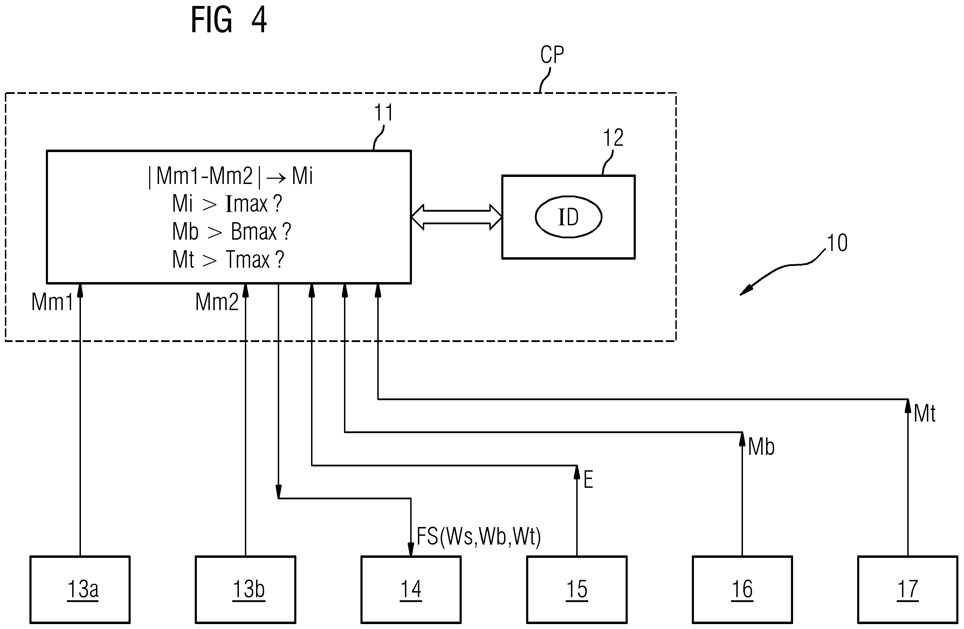

Die Figur 4 zeigt ein viertes Ausführungsbeispiel für eine Überwachungseinrichtung 10, die zur Überwachung einer Batteriezelle einsetzbar ist. Im Unterschied zu den Ausführungsbeispielen gemäß den Figuren 1 bis 3 weist die Überwachungseinrichtung 10 gemäß Figur 3 zusätzlich einen Temperatursensor 17 auf. Der Temperatursensor 17 ist geeignet, die Temperatur unter Bildung eines Temperaturmesswerts Mt zu erfassen.

Die Auswerteinrichtung 11 erzeugt ein temperaturbezogenes Warnsignal Wt, wenn der Temperaturmesswert Mt einen vorgegebenen Temperaturgrenzwert Tmax erreicht oder überschreitet. Das temperaturbezogene Warnsignal Wt wird vorzugsweise als Funksignal FS oder zusammen mit diesem an die externe Zentraleinrichtung übermittelt.

Auch ist es vorteilhaft, wenn das temperaturbezogene Warnsignal Wt, der Temperaturmesswert Mt und/oder der Umstand, dass der Temperaturmesswert Mt den Temperaturgrenzwert Tmax überschritten hat, in dem Speicher 12 abgespeichert werden, vorzugsweise unlöschbar bzw. unmanipulierbar und vorzugsweise mit Zeitangabe.

Der Temperatursensor 17 wird vorzugsweise an der im Betrieb der Batteriezelle wärmsten Stelle angeordnet.

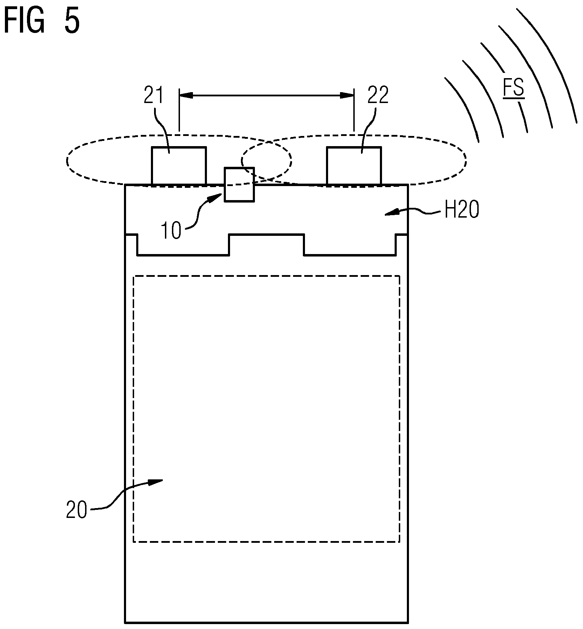

Die Figur 5 zeigt ein Ausführungsbeispiel für eine Batteriezelle 20, bei der ein Pluspol 21 und ein Minuspol 22 auf derselben Batterieseite angeordnet sind. Die Batteriezelle 20 ist mit einer Überwachungseinrichtung 10 ausgestattet, die vorzugsweise so wie oben im Zusammenhang mit den Figuren 1 bis 4 erläutert ausgestaltet ist.

Die Überwachungseinrichtung 10, zumindest aber deren aus Gründen der Übersicht nicht gezeigter Magnetfeldsensor bzw. nicht gezeigten Magnetfeldsensoren, sind asymmetrisch zu den beiden Batteriepolen 21 und 22 angeordnet, wodurch in vorteilhafter Weise vermieden wird, dass sich der Magnetfeldsensor 13 in einer Position befindet, in der das vom Batteriezellenstrom erzeugte Magnetfeld minimal ist.

Auch ist es vorteilhaft, wenn die Überwachungseinrichtung 10, zumindest aber - so vorhanden - deren Temperatursensor, im Bereich der im Betrieb heißesten Zone H20 der Batteriezelle 20 angeordnet ist.

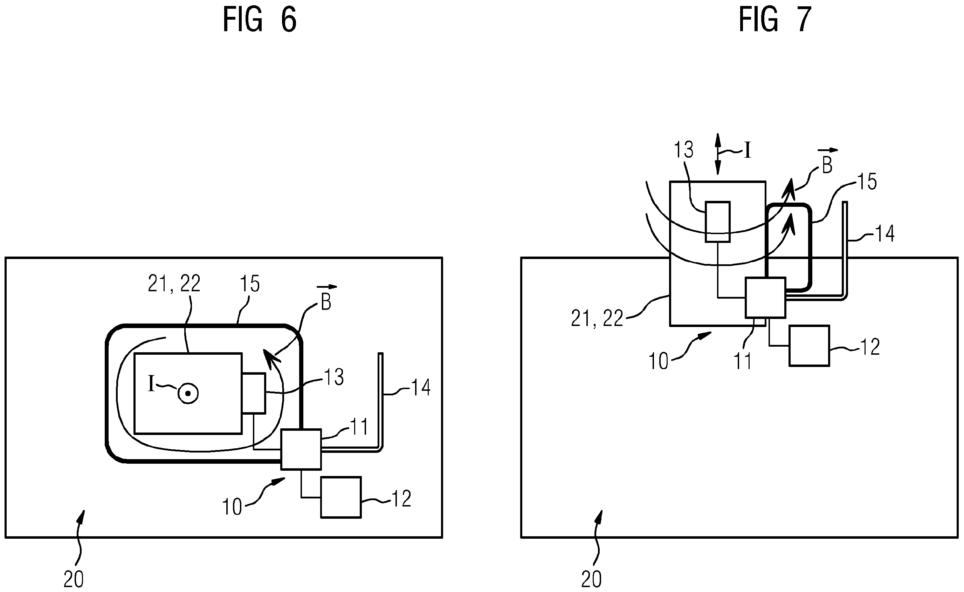

Die Figur 6 zeigt in einer schematischen Darstellung einen Abschnitt einer Batteriezelle 20, bei der einer der Batteriepole, also der Pluspol 21 oder der Minuspol 22, mit der in der Figur 1 gezeigten Überwachungseinrichtung 10 ausgestattet ist. Es lässt sich erkennen, dass die Induktionseinrichtung 15 als Induktionsschleife ausgestaltet ist, die um den Batteriepol 21/22 herumgelegt ist und somit vom - senkrecht zur Bildebene der Figur 6 fließenden - Batteriezellenstrom I der Batteriezelle 20 durchflossen wird. Kommt es zu einem abrupten Anstieg des Batteriezellenstroms I, beispielsweise im Falle eines Kurzschlusses, so wird in der Induktionseinrichtung 15 eine Spannung induziert, die Betriebsenergie E zur Aktivierung der Auswerteinrichtung 11 bereitstellt und es somit der Auswerteinrichtung 11 ermöglicht, den magnetfeldbezogenen Messwert Mm des Magnetfeldsensors 13 auszuwerten und ggf. das stromabhängige Warnsignal Ws zu erzeugen, das mittels der Sendeeinrichtung 14 in Form eines Funksignals ausgesandt wird, wie dies im Zusammenhang mit der Figur 1 beschrieben worden ist. Das Magnetfeld ist durch den magnetischen Fluss B in der Figur 6 visualisiert.

Das Warnsignal Ws, der stromabhängige Messwert Mi und/oder der Umstand, dass der stromabhängige Messwert Mi den Stromgrenzwert Imax überschritten hat, werden außerdem in dem Speicher 12 abgespeichert, vorzugsweise unlöschbar bzw. unmanipulierbar und vorzugsweise mit Zeitangabe.

Bei dem Ausführungsbeispiel gemäß Figur 6 kann die Induktionseinrichtung 15 bzw. deren Induktionsschleife im Übrigen auch selbst als Sendeeinrichtung 14 fungieren, sodass die in Figur 6 gezeigte separate Sendeeinrichtung 14 entfallen kann.

Die Figur 7 zeigt anhand eines weiteren Ausführungsbeispiels für eine erfindungsgemäße Batteriezelle eine andere Anordnung der Induktionseinrichtung 15. Es lässt sich erkennen, dass die Induktionseinrichtung 15 nicht um den Batteriepol 21 bzw. 22 herumgeführt ist, sondern stattdessen seitlich an diesem anliegt. Ein vom Batteriezellenstrom erzeugtes Magnetfeld wird somit in der Induktionseinrichtung 15 eine Spannung induzieren, wenn es zu einer abrupten Änderung des Batteriezellenstroms kommt. Im Übrigen gelten die obigen Erläuterungen im Zusammenhang mit der Figur 6 bei dem Ausführungsbeispiel gemäß Figur 7 entsprechend.

Die Figur 8 zeigt ein weiteres Ausführungsbeispiel für eine erfindungsgemäße Batteriezelle 20. Die Batteriezelle 20 gemäß Figur 8 ist mit der Überwachungseinrichtung 10 gemäß Figur 2 ausgestattet. Ein erster der beiden Magnetfeldsensoren, beispielsweise der Magnetfeldsensor 13a, ist im Bereich des Pluspols 21 und der andere zweite Magnetfeldsensor 13b im Bereich des Minuspols 22 angeordnet.

Der erste Magnetfeldsensor 13a bildet einen ersten stromabhängigen Hilfsmesswert Mm1 (siehe Figur 2) und der zweite Magnetfeldsensor 13b einen zweiten stromabhängigen Hilfsmesswert Mm2 (siehe Figur 2). Die Auswerteinrichtung 11 bildet die Differenz zwischen den beiden Hilfsmesswerten und verarbeitet die Differenz als den stromabhängigen Messwert Mi weiter, wie dies oben im Zusammenhang mit der Figur 2 erläutert wurde.

Durch die bei dem Ausführungsbeispiel gemäß Figur 8 vorgesehene Differenzbildung, die die unterschiedlichen Flussrichtungen des durch den Batteriezellenstrom hervorgerufenen Magnetfelds berücksichtigt, lässt sich in vorteilhafter Weise erreichen, dass ein externes Magnetfeld Bext, also ein Magnetfeld, das nicht auf dem Batteriezellenstrom I beruht, bei der Bildung des stromabhängigen Messwertes Mi unterdrückt wird bzw. keine Rolle spielt. Der von der Überwachungseinrichtung 10 bzw. deren Auswerteinrichtung 11 erzeugte stromabhängige Messwert Mi ist somit unabhängig von dem störenden externen Magnetfeld Bext.

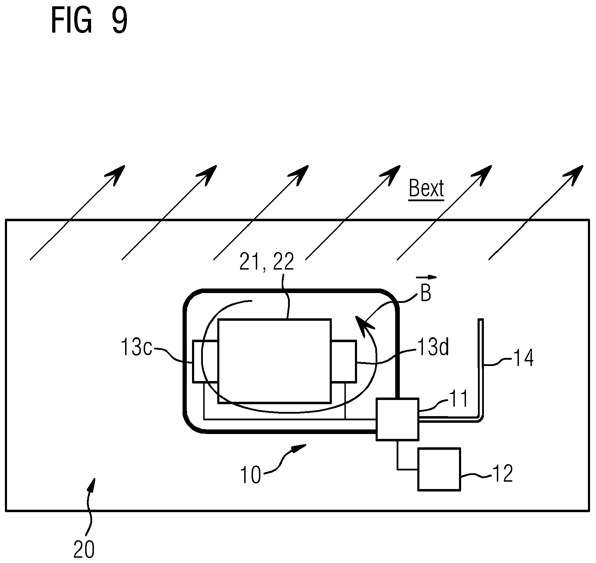

Die Figur 9 zeigt noch ein weiteres Ausführungsbeispiel für eine erfindungsgemäße Batteriezelle 20. Bei der Batteriezelle 20 gemäß Figur 9 sind im Bereich eines der Batteriepole 21/22 zwei Magnetfeldsensoren 13c und 13c angeordnet, die jeweils magnetfeldbezogene und damit stromabhängige Messwerte erzeugen. Die Auswerteinrichtung 11 kann die Messwerte beispielsweise mitteln, um Messfehler zu reduzieren.

Die oben im Zusammenhang beschriebenen Ausführungsbeispiele beziehen sich jeweils auf eine Batteriezelle. Im Falle einer Batterie, die zwei oder mehr Batteriezellen aufweist, wird vorzugsweise jede Batteriezelle jeweils mit einer Überwachungseinrichtung 10 ausgestattet.

Bei den Batteriezellen kann es sich um beliebige galvanische Zellen handeln, beispielsweise um prismatische Zellen, Pouch-Zellen oder gewickelte Zellen, wobei die Anordnung der Batteriepole beliebig ist.

Die oben anhand von Ausführungsbeispielen näher beispielhaft beschriebenen Batteriezellen und Überwachungseinrichtungen können einzelne, mehrere oder alle der nachfolgend stichpunktartig aufgeführten Merkmale oder Vorteile aufweisen:
- Jede Zelle erhält vorzugsweise einen oder mehrere Chips (z. B. Mikrocontroller), der die Messungen durchführt, ggf. zwischenspeichert, und diese drahtlos über Funk, Infrarot oder optisch rückmeldet.
- Der Chip ist vorzugsweise in der Lage, eine oder mehrere der Messungen an der Zelle vorzunehmen, mit dem Ziel, den genauen Zustand der Zelle zu erfassen, zum Beispiel durch:
   Messung elektrischer Potentiale, Ultraschallmessung, ultraviolet-visuelle Lichtmessung, Impedanzmessung, durch Einbringen einer Wechselspannung, magnetische Resonanzmessung, Shuntstrom-Messung, Temperaturmessung, Messen elektrischer Spannungen zwischen zwei Messpunkten.
- Bevorzugte Funkbänder und Protokolle zur Übertragung der Daten sind NFC, LORA, WIFI, Bluetooth, 440MHz, 880MHz, 2.4GHz, 5GHz, 60GHz etc. Die Übertragung sollte vorzugsweise verschlüsselt erfolgen und jeder Chip sollte sich vorzugsweise eindeutig (z. B. über eindeutige Seriennummer/Zertifikat) authentifizieren können. Dies ist aus Sicherheitsgründen empfehlenswert.
- Die Position des Chips (bzw. der Chips) und deren Sensoren kann vorzugsweise im Zellgehäuse oder außerhalb der Zelle am Zellgehäuse sein, mit dem Ziel, die wärmsten Positionen in der Zelle, nahe den Elektroden oder die für die Alterung der Zelle bestimmenden Zustandsgrößen (z. B. State of Charge) zu messen. Folgende Positionen sind vorteilhaft:
   im Zellgehäuse zwischen Plus- und Minus-Pol oder in deren unmittelbarer Nähe; asymmetrisch oder symmetrisch zwischen Plus- und Minus-Pol; in der Nähe des heißesten Pols im Betrieb, sodass die heißeste Stelle der Zelle im Betrieb aufgezeichnet wird (dies kann je nach Zellaufbau variieren) .
- Bei Einsatz mehrerer Chips können diese verteilt im Zellgehäuse untergebracht sein.
- Sollte der Chip außerhalb der Zelle zwischen Plus- und Minus-Pol implementiert werden, ist der Chip vorzugsweise fest mit der Zelle verbunden, und zwar derart, dass ein Entfernen deutlich sichtbar ist und damit Manipulationen an den Batterien und Zellen sofort aufgedeckt werden können.
- Chip und Zelle bilden vorzugsweise eine Einheit.
- Der Chip kann auch in der Zelle direkt im Zellwickel oder Zellstack zwischen Anode und Separator oder Kathode und Separator oder direkt im Separator positioniert/implementiert sein. Die Position des Chips ist dabei vorzugsweise zentriert im Zellwickel. Bei Einsatz mehrerer Chips können diese verteilt im Zellwickel sein.
- Die Übertragung der batterierelevanten Messdaten (Strom, Spannung, Temperatur, etc.) erfolgt vorzugsweise drahtlos durch einen Chip, der fest in der Zelle integriert ist und von dieser spannungsseitig versorgt wird. Dieser Chip hat vorzugsweise auch einen Speicher, der im Falle einer Verbindungsunterbrechung Daten zwischenspeichern kann.
- Wichtige Daten, die für die Gewährleistung relevant sind (z. B. Anzahl der Temperatur/Spannungs Über-/Unterschreitungen, etc.) werden vorzugsweise permanent auf dem Chip gespeichert und können nicht gelöscht werden (Gewährleistung) .
- Der Chip enthält vorzugsweise zudem eine eindeutige Seriennummer, die ihn bzw. die Batteriezelle eindeutig identifiziert.
- Vorzugsweise erfolgt eine Aufzeichnung der Daten zu jedem Zeitpunkt.
- Interne Messungen von Spannung, Temperatur etc. sind robuster gegen elektromagnetische Störungen (EMV) verglichen mit externen Messungen, bei denen Störungen eingekoppelt werden können.
- Die Batteriezelle weist vorzugsweise ein "elektronisches Typenschild" auf. Der Zustand jeder Zelle (Ladezustand, Lebensdauer, ...) ist vorzugsweise auch während des Transports vom Zellhersteller zum Systemintegrator nachverfolgbar.
- Es besteht keine Notwendigkeit einer Spannungsisolierung bei Hochvoltbatterien, da die Übertragung der Daten/Informationen vorzugsweise drahtlos erfolgt und daher keine nach außen führenden Messleitungen notwendig sind.
- Der Chip wird vorzugsweise von der Batterie direkt mit Energie versorgt. Die Leistungsaufnahme ist im Vergleich mit der Kapazität der Zelle in der Regel extrem gering, sodass diese vernachlässigt werden kann. Eine Tiefenentladung durch den Stromverbrauch des Chips ist auch bei langer Lagerung dadurch in der Regel ausgeschlossen.
- Beschleunigungs- und Lagesensoren im Chip messen vorzugsweise, ob die Zelle korrekt gelagert wurde (z. B. aufrecht) und nicht umgefallen ist. Außerdem werden Stöße erfasst. So kann zu jedem Zeitpunkt erfasst werden, ob die Zelle beim Transport z. B. hingefallen ist.
- Der Chipsensor wird vorzugsweise in einem fest definierten Abstand zu einem der Anschlüsse so positioniert, dass eine zumindest grobe Strommessung (Toleranzen von +/-10%) möglich ist. Durch diesen groben Stromsensor können unter Einsatz eines Hallsensors (oder vergleichbarem Magnetfeldsensor oder Magnetflusssensor) Kurzschlusszustände innerhalb der Batterie sicher erkannt werden. Dafür kann der Hallsensor des Chips unsymmetrisch zu den Stromschienen angeordnet werden, sodass ein durch den Zellstrom verursachtes Magnetfeld gemessen werden kann.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

### Bezugszeichenliste

- 10: Überwachungseinrichtung
- 11: Auswerteinrichtung
- 12: Speicher
- 13: Magnetfeldsensor
- 13a: Magnetfeldsensor
- 13b: Magnetfeldsensor
- 13c: Magnetfeldsensor
- 13d: Magnetfeldsensor
- 14: Sendeeinrichtung
- 15: Induktionseinrichtung
- 16: Beschleunigungssensor
- 17: Temperatursensor
- 20: Batteriezelle
- 21: Pluspol
- 22: Minuspol

- B: magnetischer Fluss / Magnetfeld
- Bext: externes Magnetfeld
- Bmax: Beschleunigungsgrenzwert
- CP: Chip
- dMb/dt: Stoßmesswert
- E: Betriebsenergie
- FS: Funksignal
- H20: heißeste Zone der Batteriezelle
- I: Batteriezellenstrom
- ID: Identifikationsangabe
- Imax: Stromgrenzwert
- Mb: Beschleunigungsmesswert
- Mi: stromabhängiger Messwert
- Mm: magnetfeldbezogener Messwert
- Mm1: stromabhängiger Hilfsmesswert
- Mm2: stromabhängiger Hilfsmesswert
- Mm1-Mm2: Differenz
- Mt: Temperaturmesswert
- Tmax: Temperaturgrenzwert
- Wb: beschleunigungsbezogenes Warnsignal
- Ws: stromabhängiges Warnsignal
- Wt: temperaturbezogenes Warnsignal

## Patentansprüche

1. Batteriezelle (20) mit einer Überwachungseinrichtung (10), die geeignet ist, zumindest einen die Batteriezelle (20) betreffenden stromabhängigen Messwert (Mi) zu erfassen, **dadurc hgekennzeichnet**, dass
- die Überwachungseinrichtung (10) einen Magnetfeldsensor (13, 13a, 13b) umfasst, der geeignet ist, ein von einem durch die Batteriezelle (20) fließenden elektrischen Batteriezellenstrom (I) erzeugtes Magnetfeld (B) unter Bildung eines magnetfeldbezogenen Messwerts (Mm, Mm1, Mm2) zu erfassen und
- die Überwachungseinrichtung (10) den magnetfeldbezogenen Messwert (Mm, Mm1, Mm2) unmittelbar als den stromabhängigen Messwert (Mi) weiterverarbeitet oder den stromabhängigen Messwert (Mi) mit dem magnetfeldbezogenen Messwert (Mm, Mm1, Mm2) bildet.

2. Batteriezelle (20) nach Anspruch 1,
**dadurch gekennzeichnet, dass** die Überwachungseinrichtung (10) von den Batteriepolen (21, 22) der Batteriezelle (20) elektrisch getrennt ist und eine Energieversorgung der Überwachungseinrichtung (10) auf einer induzierten elektrischen Spannung und/oder einem induzierten elektrischen Strom basiert, die bzw. der im Falle eines sich ändernden Magnetfelds (B) in der Überwachungseinrichtung (10) induziert wird.

3. Batteriezelle (20) nach einem der voranstehenden Ansprüche,
**dadurc hgekennzeichnet**, dass der Magnetfeldsensor (13, 13a, 13b) asymmetrisch zu den Batteriepolen (21, 22) der Batteriezelle (20) angeordnet ist.

4. Batteriezelle (20) nach einem der voranstehenden Ansprüche,
**dadurch gekennzeichnet, dass** der Magnetfeldsensor (13, 13a, 13b) ein Feldstärkesensor ist, der die magnetische Feldstärke des Magnetfelds (B) misst, oder ein Flusssensor ist, der den magnetischen Fluss des Magnetfelds (B) misst.

5. Batteriezelle (20) nach einem der voranstehenden Ansprüche,
**dadurch gekennzeichnet, dass** der Magnetfeldsensor (13, 13a, 13b) ein Hallsensor, ein magnetoresistiver Sensor, ein magnetomechanischer Sensor, ein GMR-Sensor bzw. ein riesenmagnetowiderstandsbasierter Sensor, ein TMR-Sensor bzw. magnetischer tunnelwiderstandsbasierter Sensor oder ein Rogowskispulensensor ist.

6. Batteriezelle (20) nach einem der voranstehenden Ansprüche,
**dadurc hgekennzeichnet**, dass
- die Überwachungseinrichtung (10) zumindest einen ersten und einen zweiten Magnetfeldsensor (13a, 13b) umfasst, die jeweils geeignet sind, ein von einem durch die Batteriezelle (20) fließenden elektrischen Batteriezellenstrom (I) erzeugtes Magnetfeld (B) unter Bildung eines stromabhängigen Hilfsmesswerts (Mm1, Mm2) zu erfassen, wobei
- der erste Magnetfeldsensor (13a) näher am Pluspol (21) der Batteriezelle (20) angeordnet ist als der zweite Magnetfeldsensor (13b) und einen ersten stromabhängigen Hilfsmesswert (Mm1) bildet,
- der zweite Magnetfeldsensor (13b) näher am Minuspol (22) der Batteriezelle (20) angeordnet ist als der erste Magnetfeldsensor (13a) und einen zweiten stromabhängigen Hilfsmesswert (Mm2) bildet und
- die Überwachungseinrichtung (10) die Differenz (Mm1-Mm2) zwischen den beiden Hilfsmesswerten (Mm1, Mm2) bildet und die Differenz (Mm1-Mm2) als den stromabhängigen Messwert (Mi) weiterverarbeitet.

7. Batteriezelle (20) nach einem der voranstehenden Ansprüche,
**dadurc hgekennzeichnet**, dass die Überwachungseinrichtung (10) ein stromabhängiges Warnsignal (Ws) erzeugt, wenn sie mit induzierter Energie versorgt wird und der stromabhängige Messwert (Mi) einen vorgegebenen Stromgrenzwert (Imax), der einen unzulässig hohen Batteriezellenstrom (I) signalisiert, erreicht oder überschreitet.

8. Batteriezelle (20) nach einem der voranstehenden Ansprüche,
**dadurc hgekennzeichnet**, dass die Überwachungseinrichtung (10) einen Beschleunigungssensor (16) umfasst, der geeignet ist, die Beschleunigung unter Bildung eines Beschleunigungsmesswerts (Mb) zu erfassen.

9. Batteriezelle (20) nach Anspruch 8,
**dadurc hgekennzeichnet**, dass die Überwachungseinrichtung (10) ein beschleunigungsbezogenes Warnsignal (Wb) erzeugt, wenn der Beschleunigungsmesswert (Mb) einen vorgegebenen Beschleunigungsgrenzwert (Bmax) oder ein durch zeitliche Ableitung des Beschleunigungsmesswerts (Mb) ermittelter Stoßmesswert einen vorgegebenen Stoßgrenzwert erreicht oder überschreitet.

10. Batteriezelle (20) nach einem der voranstehenden Ansprüche,
**dadurch gekennzeichnet, dass** die Überwachungseinrichtung (10) einen Temperatursensor (17), der geeignet ist, die Temperatur unter Bildung eines Temperaturmesswerts (Mt) zu erfassen, aufweist.

11. Batteriezelle (20) nach einem der voranstehenden Ansprüche,
**dadurch gekennzeichnet, dass** die Überwachungseinrichtung (10) einen Speicher (12) aufweist, in dem die Überwachungseinrichtung (10) erfasste Strommesswerte (Mi), Beschleunigungsmesswerte (Mb), Stoßmesswerte und/oder Temperaturmesswerte (Mt) dauerhaft abspeichert.

12. Batteriezelle (20) nach einem der voranstehenden Ansprüche,
**dadurch gekennzeichnet, dass** die Überwachungseinrichtung (10) eine Sendeeinrichtung (14) aufweist, die geeignet ist, erfasste Strommesswerte (Mi), Beschleunigungsmesswerte (Mb), Stoßmesswerte, Temperaturmesswerte (Mt), Zustandsangaben, die auf Strommesswerten (Mi), Beschleunigungsmesswerten (Mb), Stoßmesswerten und/oder Temperaturmesswerten (Mt) basieren, und/oder Warnsignale (Ws, Wb, Wt) per Funk auszusenden.

13. Batteriezelle (20) nach einem der voranstehenden Ansprüche,
**dadurch gekennzeichnet, dass** der Überwachungseinrichtung (10) und damit der Batteriezelle (20) eine Identifikationsangabe (ID) zugeordnet ist, die in einem Chip (CP) der Überwachungseinrichtung (10) oder einem die Überwachungseinrichtung (10) bildenden Chip (CP) abgespeichert ist.

14. Batterie, die ein oder mehr Batteriezellen (20) umfasst, **dadurch gekennzeichnet, dass** die oder zumindest eine der Batteriezellen (20) nach einem der voranstehenden Ansprüche ausgestaltet sind.

15. Verfahren zum Überwachen einer Batteriezelle (20) unter Erfassung zumindest eines stromabhängigen Messwerts (Mi), **dadurch gekennzeichnet, dass**
- mit einem Magnetfeldsensor (13, 13a, 13b) ein von einem durch die Batteriezelle (20) fließenden elektrischen Batteriezellenstrom (I) erzeugtes Magnetfeld (B) unter Bildung eines magnetfeldbezogenen Messwerts (Mm, Mm1, Mm2) erfasst wird und
- der magnetfeldbezogene Messwert (Mm, Mm1, Mm2) unmittelbar als der stromabhängige Messwert (Mi) weiterverarbeitet wird oder der stromabhängigen Messwert (Mi) mit dem magnetfeldbezogenen Messwert (Mm, Mm1, Mm2) gebildet wird.
